# EUROPEAN PATENT APPLICATION

(11) **EP 4 497 841 A1**
(43) Date of publication of application: **29.01.2025**
(21) Application number: 24173694.1
(22) Date of filing: 01.05.2024
(51) Int. Cl.: C23C 14/04

(54) **MASK ASSEMBLY AND MANUFACTURING METHOD OF THE SAME**

(30) Priority: 16.05.2023 KR 20230062802
(71) Applicant: Samsung Display Co., Ltd., Yongin-si, Gyeonggi-do 17113 (KR)
(72) Inventor: KIM, Yonghwan, Yongin-si (KR); MOON, Jaesuk, Seongnam-si (KR); LEE, Sangshin, 17113 Yongin-si (KR); LEE, Seungjin, Suwon-si (KR)
(74) Representative: Marks & Clerk LLP

(57) **Abstract**

A mask assembly includes: a mask and a mask frame, which supports the mask. The mask includes: a plurality of sub-masks, which are arranged in a first direction and each include a short side that extends in the first direction and a long side that extends in a second direction crossing the first direction; and a connecting stick, which overlaps the long side in a plan view and connects two sub-masks adjacent to each other among the plurality of sub-masks. Each of the plurality of sub-masks includes: a central part including a cell region defining a plurality of holes therein; and a welding part disposed along the long side. The connecting stick and the welding part are connected with each other through a plurality of welding agents.

## Description

### BACKGROUND

Embodiments of the present disclosure described herein relate to a mask assembly and a manufacturing method thereof.

A display panel includes a plurality of pixels. The pixels include drive elements such as transistors and display elements such as organic light emitting diodes, respectively. The display elements may be formed by stacking electrodes and emission patterns on a substrate.

The emission patterns are subjected to patterning using a mask having opening regions defined in predetermined regions thereof. The emission patterns of the display elements may be formed to correspond to the opening regions of the mask. In order to improve manufacturing efficiency of the display elements, development for the shape or number of opening regions of the mask is in progress.

### SUMMARY

Embodiments of the present disclosure provide a mask assembly with reliability and a manufacturing method thereof.

According to an embodiment, a mask assembly includes: a mask and a mask frame, which supports the mask. The mask includes: a plurality of sub-masks, which are arranged in a first direction and each include a short side that extends in the first direction and a long side that extends in a second direction crossing the first direction; and a first connecting stick, which overlaps the long side in a plan view and connects two sub-masks adjacent to each other among the plurality of sub-masks. Each of the plurality of sub-masks includes: a central part including a cell region defining a plurality of holes therein; and a welding part disposed along the long side. The first connecting stick and the welding part are connected with each other through a plurality of welding agents.

The first connecting stick may be disposed under the two sub-masks adjacent to each other and may partially overlap the welding part included in each of the two sub-masks in the plan view.

The plurality of welding agents may overlap the welding part and the first connecting stick in the plan view.

The plurality of welding agents may be disposed under the first connecting stick.

The plurality of welding agents may be disposed on the welding part.

The plurality of welding agents might not overlap the central part in the plan view.

The first connecting stick and the welding part may partially overlap each other in the plan view.

Each of the plurality of sub-masks may further include an alignment part having an alignment mark to determine whether the two sub-masks adjacent to each other among the plurality of sub-masks are aligned with each other.

The alignment part may be disposed between the central part and the welding part.

The alignment mark may include a photoresist pattern.

The alignment mark may be provided in plurality (i.e. the alignment mark includes or comprises a plurality of alignment marks), and the plurality of alignment marks may be aligned in the second direction.

Each of the plurality of sub-masks may include: a first alignment part disposed in the first direction with respect to the central part and a second alignment part disposed opposite to the first alignment part with respect to the central part.

The plurality of alignment marks may include a plurality of first alignment marks defined on the first alignment part and a plurality of second alignment marks defined on the second alignment part.

The plurality of first alignment marks defined on one sub-mask among the plurality of sub-masks and the plurality of second alignment marks defined on another sub-mask adjacent to the one sub-mask may be aligned with each other in the first direction.

The cell region may be singly provided in the central part.

The mask may further include: two tensile parts connected with two outermost sub-masks (i.e. two sub-masks disposed furthest from the middle) in the first direction and a direction opposite to the first direction, respectively, among the plurality of sub-masks, and the two tensile parts may be fixed to the mask frame.

The mask may further include a second connecting stick configured to connect the two outermost sub-masks with the two tensile parts.

Each of the two tensile parts may include a tensile welding part, and the tensile welding part and the welding part may be connected by the second connecting stick.

The first connecting stick may be provided in plurality, and the plurality of first connecting sticks may be arranged in the first direction.

Each of the plurality of first connecting sticks may extend along the long side.

Each of the plurality of first connecting sticks may include a plurality of sub-connecting sticks arranged along the long side.

The short side may have a length of about 90 millimeters (mm) to about 400 mm, and the long side may have a length of about 300 mm to about 2000 mm.

According to an embodiment, a mask assembly includes: a mask and a mask frame, which supports the mask. The mask includes: a plurality of sub-masks, which are arranged in a first direction and each include a short side that extends in the first direction and a long side that extends in a second direction crossing the first direction. Each of the plurality of sub-masks includes: a central part including a single cell region defining a plurality of holes therein; and a welding part, which extends from the central part and is adjacent to the long side. Welding parts included in two sub-masks adjacent to each other among the plurality of sub-masks are connected with each other.

The mask may further include a connecting stick that overlaps the long side in a plan view and connects the two sub-masks adjacent to each other.

The connecting stick and the welding part may partially overlap each other in the plan view.

The welding parts included in the two sub-masks adjacent to each other may make direct contact with each other.

Each of the welding parts (particularly those included in the two sub-masks adjacent to each other) may include an inclined surface or a stepped surface.

According to an embodiment, a method for manufacturing a mask assembly includes: preparing a plurality of preliminary sub-masks, which are arranged in a first direction and each include a short side that extends in the first direction and a long side that extends in a second direction crossing the first direction; stretching the plurality of preliminary sub-masks in the second direction and a direction opposite to the second direction to provide a plurality of sub-masks; connecting two sub-masks adjacent to each other among the plurality of sub-masks through a connecting stick to provide a mask; and placing the mask on a mask frame. Each of the plurality of sub-masks includes: a central part including a cell region defining a plurality of holes therein; and a welding part, which is adjacent to the long side and makes contact with the connecting stick. The connecting stick and the welding part partially overlap each other in a plan view.

Each of the plurality of preliminary sub-masks may include a first sub-tensile part that extends from the central part in the second direction and a second sub-tensile part that extends from the central part in a direction opposite to the second direction.

The stretching of the plurality of preliminary sub-masks may include stretching the first sub-tensile part in the second direction using a first stretching unit connected with the first sub-tensile part and stretching the second sub-tensile part in the direction opposite to the second direction using a second stretching unit connected with the second sub-tensile part.

The plurality of sub-masks may be provided by cutting the first sub-tensile part and the second sub-tensile part after the stretching of the first sub-tensile part and the second sub-tensile part.

The connecting of the two sub-masks through the connecting stick may include placing the connecting stick on the welding part; and welding the welding part and the connecting stick above the connecting stick, or welding the welding part and the connecting stick to form a welding agent on the connecting stick.

The connecting of the two sub-masks through the connecting stick may include placing the connecting stick under the welding part and welding the welding part and the connecting stick above the welding part, or welding the welding part and the connecting stick to form a welding agent on the connecting stick.

The method may further include determining whether the sub-masks are aligned, before the connecting of the two sub-masks through the connecting stick.

Determining whether the sub-masks are aligned may include: determining whether the sub-masks are aligned, by using outmost holes, among the plurality of holes included in one of the two sub-masks, adjacent to another sub-mask of the two sub-masks.

The sub-masks may define a welding hole therein in which a welding agent is formed, and determining whether the sub-masks are aligned may include determining whether the sub-masks are aligned, by using the welding hole.

Each of the plurality of sub-masks may further include an alignment part having an alignment mark defined thereon, and determining whether the sub-masks are aligned may further include forming the alignment mark on the alignment part.

Determining whether the sub-masks are aligned may further include determining whether the sub-masks are aligned, by using the alignment mark.

Each of two outermost sub-masks (e.g. those disposed furthest from the middle) in the first direction and a direction opposite to the first direction, respectively, among the plurality of sub-masks may further include a tensile part that extends from the central part.

The method may further include stretching the sub-masks by stretching the tensile parts of the two outermost sub-masks in the first direction and the direction opposite to the first direction, after the connecting of the two adjacent sub-masks through the connecting stick; and fixing the sub-masks to the mask frame.

The method may further include stretching the sub-masks connected through the tensile part in the first direction and a direction opposite to the first direction and fixing the sub-masks to the mask frame, after the connecting of the two adjacent sub-masks through the connecting stick.

At least some of the above and other features of the invention are set out in the claims.

### BRIEF DESCRIPTION OF THE FIGURES

The above and other objects, aspects and features of the present disclosure will become apparent by describing in detail embodiments thereof with reference to the accompanying drawings.
FIG. 1 is a plan view of a mask assembly according to an embodiment of the present disclosure.
FIG. 2 is a perspective view of a mask according to an embodiment of the present disclosure.
FIG. 3 is an enlarged view of region AA' illustrated in FIG. 1.
FIG. 4A is a cross-sectional view illustrating a mask and a deposition substrate disposed on the mask according to an embodiment of the present disclosure.
FIG. 4B is a cross-sectional view illustrating a mask and a deposition substrate disposed on the mask according to another embodiment of the present disclosure.
FIG. 5A is a cross-sectional view of a mask according to an embodiment of the present disclosure.
FIG. 5B is a cross-sectional view of a mask according to an embodiment of the present disclosure.
FIG. 6A is an enlarged view of a portion of a mask according to an embodiment of the present disclosure.
FIG. 6B is an enlarged view of a portion of a mask according to an embodiment of the present disclosure.
FIG. 7 is an enlarged view of a portion of a mask according to an embodiment of the present disclosure.
FIG. 8 is a flowchart illustrating a method of manufacturing a mask assembly according to an embodiment of the present disclosure.
FIGS. 9A to 9F are schematic process views illustrating processes of manufacturing the mask assembly according to an embodiment of the present disclosure.
FIGS. 10A to 10C are schematic process views illustrating processes of manufacturing the mask assembly according to an embodiment of the present disclosure.
FIGS. 11A to 11C are views illustrating a step of determining whether two adjacent preliminary sub-masks are aligned with each other according to an embodiment of the present disclosure.

### DETAILED DESCRIPTION

Various changes can be made to the present disclosure, and various embodiments of the present disclosure may be implemented. Thus, specific embodiments are illustrated in the drawings and described as examples herein. However, it should be understood that the present disclosure is not to be construed as being limited thereto and covers all modifications, equivalents, and alternatives falling within the scope of the present disclosure.

In this specification, when it is mentioned that a component (or, an area, a layer, a part, etc.) is referred to as being "on", "connected to" or "coupled to" another component, this means that the component may be directly on, connected to, or coupled to the other component or a third component may be present therebetween.

Identical reference numerals refer to identical components. Additionally, in the drawings, the thicknesses, proportions, and dimensions of components are exaggerated for effective description.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes all of one or more combinations defined by related components.

Terms such as "first", "second", and the like may be used to describe various components, but the components should not be limited by the terms. The terms may be used only for distinguishing one component from other components. For example, without departing the scope of the present disclosure, a first component may be referred to as a second component, and similarly, the second component may also be referred to as the first component. The terms of a singular form may include plural forms unless otherwise specified.

In addition, terms such as "below", "under", "above", and "over" are used to describe a relationship of components illustrated in the drawings. The terms are relative concepts and are described based on directions illustrated in the drawing.

Unless otherwise defined, all terms used herein, including technical or scientific terms, have the same meanings as those generally understood by those skilled in the art to which the present disclosure pertains. Such terms as those defined in a generally used dictionary are to be interpreted as having meanings equal to the contextual meanings in the relevant field of art, and are not to be interpreted as having ideal or excessively formal meanings unless clearly defined as having such in the present application.

It should be understood that terms such as "comprise", "include", and "have", when used herein, specify the presence of stated features, numbers, steps, operations, components, parts, or combinations thereof, but do not preclude the presence or addition of one or more other features, numbers, steps, operations, components, parts, or combinations thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value. Hereinafter, embodiments of the present disclosure will be described with reference to the accompanying drawings.

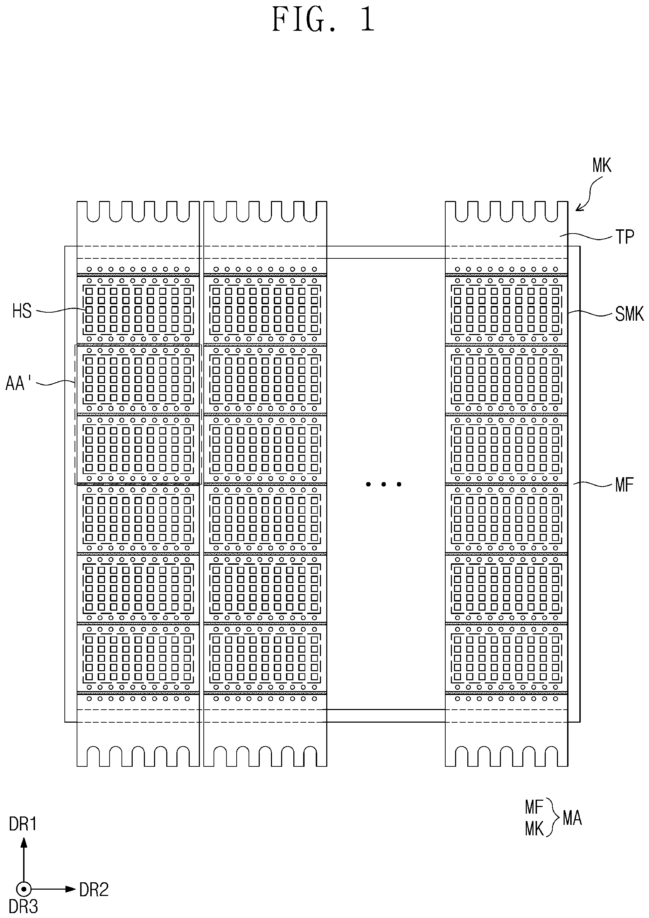

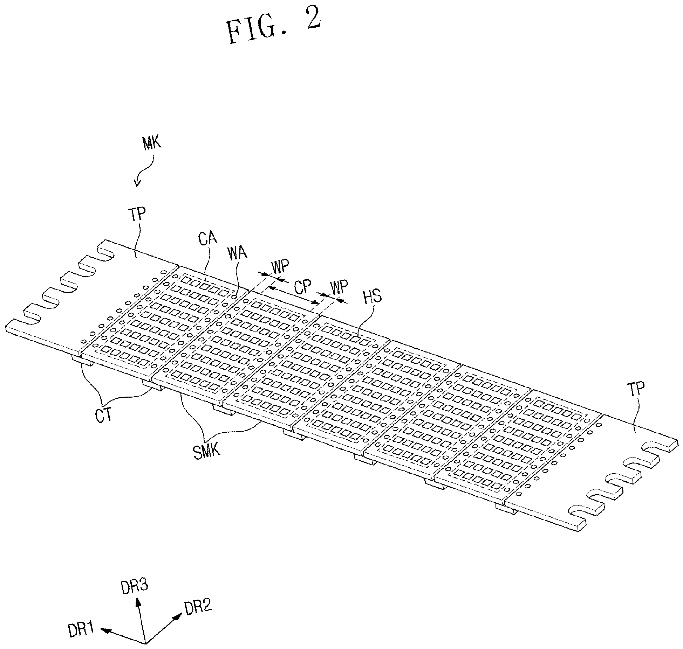

FIG. 1 is a plan view of a mask assembly according to an embodiment of the present disclosure. FIG. 2 is a perspective view of a mask according to an embodiment of the present disclosure.

The mask assembly MA may be used in a process of manufacturing display devices. Specifically, the mask assembly MA may be used in a process of depositing organic light emitting element layers on deposition substrates of the display devices.

Referring to FIGS. 1 and 2, the mask assembly MA may include a plurality of masks MK and a mask frame MF. The mask assembly MA may have a quadrangular shape with sides extending in a first direction DR1 and sides extending in a second direction DR2. However, without being limited thereto, the mask assembly MA may have various shapes to correspond to the shapes of the display devices.

Hereinafter, a direction substantially vertically crossing a plane defined by the first direction DR1 and the second direction DR2 is defined as a third direction DR3. The expression "when viewed from above the plane" (in other words, "in a plan view") used herein may mean that it is viewed in the third direction DR3.

The mask frame MF may have a quadrangular closed-line shape when viewed from above the plane. Specifically, the mask frame MF may include two frames extending in the first direction DR1 and two frames extending in the second direction DR2. An opening may be defined in a central portion of the mask frame MF as the frames are connected together.

The mask frame MF may have sufficient rigidity. For example, the mask frame MF may include a metallic material such as stainless steel ("SUS"), an Invar alloy, nickel (Ni), cobalt (Co), or the like.

The masks MK may be fixed to the mask frame MF. For example, the masks MK may be fixed to the mask frame MF in a state of being arranged in the second direction DR2. Each of the masks MK may extend in the first direction DR1. In this embodiment, the mask frame MF may have a length of about 2000 millimeters (mm) or more in the first direction DR1. Accordingly, the length of the mask MK in the first direction DR1 may be greater than or equal to the length of the mask frame MF in the first direction DR1. For example, the length of the mask frame MF and the length of the mask MK in the first direction DR1 may be about 2000 mm or more. However, without being limited thereto, the mask frame MF may have a length of about 1200 mm or less and is not limited to any one embodiment. As illustrated in FIG. 1, the plurality of masks MK may be provided.

Each of the masks MK may include a plurality of sub-masks SMK arranged in the first direction DR1 and a plurality of connecting sticks CT, each of which connects two sub-masks SMK adjacent to each other among the plurality of sub-masks SMK.

Each of the plurality of sub-masks SMK may have short sides extending in the first direction DR1 and long sides extending in the second direction DR2. When viewed from above the plane, each of the plurality of sub-masks SMK may have a rectangular shape with two short sides extending in the first direction DR1 and two long sides extending in the second direction DR2. Although FIG. 2 illustrates a structure in which six sub-masks SMK are included in each mask MK, the number of sub-masks SMK is not limited thereto.

Each of the plurality of sub-masks SMK may include a central part CP in which a cell region CA including a plurality of holes HS is defined and welding parts WP extending from opposite sides of the central part CP in the first direction DR1 and the direction opposite to the first direction DR1.

The cell region CA may be defined in a portion of the central part CP. The cell region CA may have a quadrangular shape when viewed from above the plane. Although not illustrated, the area of the cell region CA may substantially correspond to the area of one display device. According to an embodiment of the present disclosure, the cell region CA may be singly provided in the central part CP. That is, one cell region CA may be provided in each of the plurality of sub-masks SMK. However, without being limited thereto, a plurality of cell regions CA may be provided in the central part CP in another embodiment.

The plurality of holes HS spaced apart from each other may be defined in the cell region CA. Each of the plurality of holes HS may have a quadrangular shape when viewed from above the plane. The plurality of holes HS may be formed through the corresponding sub-masks SMK in the thickness direction (e.g., the third direction DR3). Although FIG. 2 illustrates an example that 45 holes HS are defined in one cell region CA, more or fewer holes HS may be defined in one cell region CA. In addition, the shape of each of the plurality of holes HS is not limited to a quadrangular shape and may be diversely changed.

The connecting stick CT may be disposed under the two sub-masks SMK adjacent to each other and may connect the two adjacent sub-masks SMK. Specifically, the connecting stick CT may overlap two long sides that are included in the two adjacent sub-masks SMK and that face each other and may make direct contact with two welding parts WP facing each other in a plan view. The connecting stick CT, when viewed from above the plane, may overlap the two welding parts WP facing each other in a plan view. As the plurality of sub-masks SMK are provided, the plurality of connecting sticks CT may be provided. Each of the plurality of connecting sticks CT may extend in the second direction DR2, and the plurality of connecting sticks CT may be arranged in the first direction DR1. The plurality of connecting sticks CT may extend along the long sides of the sub-masks SMK.

The welding parts WP may correspond to outer portions of the sub-masks SMK. The welding parts WP may correspond to portions where the two adjacent sub-masks SMK are connected with the connecting stick CT. A plurality of welding agents WA may be formed on the welding parts WP. The welding parts WP and the connecting stick CT may be connected by the plurality of welding agents WA through a welding process. Referring to FIG. 2, although the two welding parts WP included in the two adjacent sub-masks SMK and facing each other are illustrated as being spaced apart from each other, the welding parts WP facing each other may make direct contact with each other without being limited thereto.

The mask MK according to an embodiment of the present disclosure may further include two tensile parts TP connected with two sub-masks SMK disposed furthest from the middle in the first direction DR1 and the direction opposite to the first direction DR1 through connecting sticks CT. Each of the tensile parts TP may be directly disposed on the mask frame MF and may be fixed to the mask frame MF. For example, the tensile part TP may be fixed to the mask frame MF by clamping. As the tensile part TP is fixed to the mask frame MF, the mask MK may be fixed to the mask frame MF. After the mask MK is fixed to the mask frame MF, a portion of the tensile part TP may be removed.

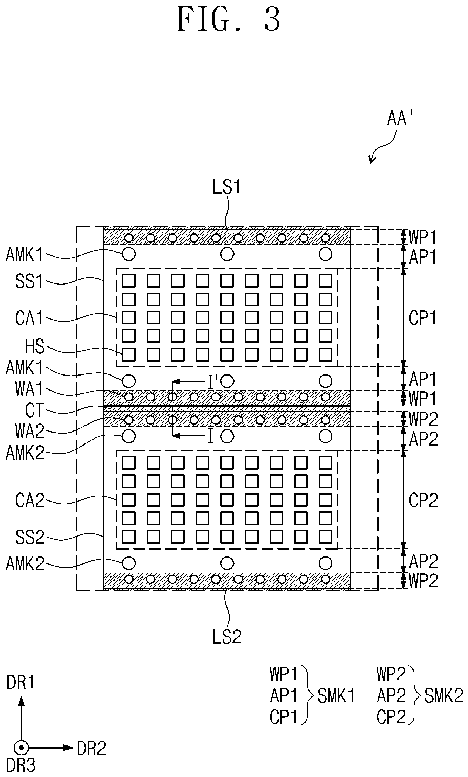

FIG. 3 is an enlarged view of region AA' illustrated in FIG. 1. FIG. 3 is an enlarged view of some of the plurality of sub-masks SMK illustrated in FIG. 2. For convenience of description, only two sub-masks (that is, a first sub-mask SMK1 and a second sub-mask SMK2) among the sub-masks SMK are illustrated in FIG. 3.

Referring to FIG. 3, the first sub-mask SMK1 and the second sub-mask SMK2 may be disposed adjacent to each other in the first direction DR1. The first sub-mask SMK1 may include two first short sides SS1 extending in the first direction DR1 and two first long sides LS1 extending in the second direction DR2, and the second sub-mask SMK2 may include two second short sides SS2 extending in the first direction DR1 and two second long sides LS2 extending in the second direction DR2. The first long sides LS1 and the second long sides LS2 may have the same length, and the first short sides SS1 and the second short sides SS2 may have the same length. The first long sides LS1 and the second long sides LS2 may be longer than the first short sides SS1 and the second short sides SS2. For example, the first long sides LS1 and the second long sides LS2 may have a length of about 300 mm to about 2000 mm, and the first short sides SS1 and the second short sides SS2 may have a length of about 90 mm to about 400 mm. Specifically, the first long sides LS1 and the second long sides LS2 may have a length of about 700 mm to about 1300 mm.

The first sub-mask SMK1 includes a first central part CP1, a first alignment part AP1, and a first welding part WP1. The first central part CP1 is disposed at the center of the first sub-mask SMK1. The first alignment part AP1 may include two portions extending from opposite sides of the first central part CP1 in the first direction DR1 and the direction opposite to the first direction DR1. The first welding part WP1 may include two portions extending from the two portions of the first alignment part AP1 in the first direction DR1 and the direction opposite to the first direction DR1. The two portions of the first welding part WP1 are adjacent to the two first long sides LS1, respectively.

The second sub-mask SMK2 includes a second central part CP2, a second alignment part AP2, and a second welding part WP2. The second central part CP2 is disposed at the center of the second sub-mask SMK2. The second alignment part AP2 may include two portions extending from opposite sides of the second central part CP2 in the first direction DR1 and the direction opposite to the first direction DR1. The second welding part WP2 may include two portions extending from the two portions of the second alignment parts AP2 in the first direction DR1 and the direction opposite to the first direction DR1. The two portions of the second welding part WP2 are adjacent to the two second long sides LS2, respectively.

A first cell region CA1 may be defined in the first central part CP1, and a second cell region CA2 may be defined in the second central part CP2. The area of the first cell region CA1 may substantially correspond to the area of one display device. As the area of the first cell region CA1 is increased, the mask MK may be used to manufacture a display device having a large area. The area of the first cell region CA1 may be proportional to the size of the first sub-mask SMK1. That is, as the size of the first sub-mask SMK1 is increased, the area of the first cell region CA1 may also be increased in proportion to the size of the first sub-mask SMK1. The description of the first cell region CA1 may be identically applied to the second cell region CA2.

Referring to FIGS. 2 and 3, the mask MK may include long sides extending in the first direction DR1 and short sides extending in the second direction DR2. In the present disclosure, the mask MK may be formed by connecting the plurality of sub-masks SMK, each of which includes the long sides having a length of about 700 mm to about 1300 mm in the second direction DR2. Accordingly, the largearea mask MK including the short sides having a length of about 700 mm or more in the second direction DR2 may be provided. In addition, as the long sides of the sub-mask SMK have a length of about 700 mm to about 1300 mm and the short sides of the sub-mask SMK have a length of about 90 mm to about 400 mm, the area of the cell region CA corresponding to the area of a display device may be increased. Accordingly, the display device having a large area may be easily provided by using the mask MK of the present disclosure.

A first alignment mark AMK1 may be defined on the first alignment part AP1, and a second alignment mark AMK2 may be defined on the second alignment part AP2. The first alignment mark AMK1 and the second alignment mark AMK2 may be used to determine whether the first sub-mask SMK1 and the second sub-mask SMK2 are aligned with each other.

A plurality of first alignment marks AMK1 and a plurality of second alignment marks AMK2 may be provided. In FIG. 3, three first alignment marks AMK1 and three second alignment marks AMK2 are illustrated. However, without being limited thereto, three or more first alignment marks AMK1 and three or more second alignment marks AMK2 may be provided in another embodiment.

The first alignment marks AMK1 and the second alignment marks AMK2 may be holes penetrating the first alignment part AP1 and the second alignment part AP2, or may be depressions formed by removing portions of surfaces of the first alignment part AP1 and the second alignment part AP2. According to an embodiment of the present disclosure, the first alignment marks AMK1 and the second alignment marks AMK2 may be patterns formed on the first alignment part AP1 and the second alignment part AP2 through a photoresist process. In FIG. 3, the first alignment marks AMK1 have the same circular shape and are arranged in the second direction DR2, and the second alignment marks AMK2 have the same circular shape and are arranged in the second direction DR2. However, without being limited thereto, the first alignment marks AMK1 and the second alignment marks AMK2 may be formed in various shapes and are not limited to any one embodiment.

The first alignment marks AMK1 and the second alignment marks AMK2 may be spaced apart from each other on the plane with the first welding part WP1 and the second welding part WP2 therebetween. The first alignment marks AMK1 may be aligned with each other in the second direction DR2. In addition, the second alignment marks AMK2 may be aligned with each other in the second direction DR2. The first alignment marks AMK1 and the second alignment marks AMK2 may be aligned with each other in the first direction DR1. For example, a first alignment mark AMK1 disposed at the center among the first alignment marks AMK1 and a second alignment mark AMK2 disposed at the center among the second alignment marks AMK2 may be aligned with each other in the first direction DR1, the first alignment marks AMK1 may be aligned with each other in the second direction DR2, and the second alignment marks AMK2 may be aligned with each other in the second direction DR2. Accordingly, whether the first sub-mask SMK1 and the second sub-mask SMK2 are aligned with each other may be easily determined. That is, through the first alignment marks AMK1 and the second alignment marks AMK2, the degree of alignment between the first sub-mask SMK1 and the second sub-mask SMK2 may be improved, and a defect rate of the mask MK (refer to FIG. 2) may be effectively decreased.

The first welding part WP1 and the second welding part WP2 may overlap the connecting stick CT on the plane. A plurality of first welding agents WA1 may be formed on the first welding part WP1, and a plurality of second welding agents WA2 may be formed on the second welding part WP2. The first welding agents WA1 and the second welding agents WA2 may be formed through a welding process. The first welding part WP1 may be fixedly connected with the connecting stick CT through the first welding agents WA1, and the second welding part WP2 may be fixedly connected with the connecting stick CT through the second welding agents WA2.

FIG. 3 illustrates an example that ten first welding agents WA1 and ten second welding agents WA2 overlap one connecting stick CT on the plane. However, without being limited thereto, the numbers of first welding agents WA1 and second welding agents WA2 may be diversely set depending on the lengths of the first long sides LS1 and the second long sides LS2.

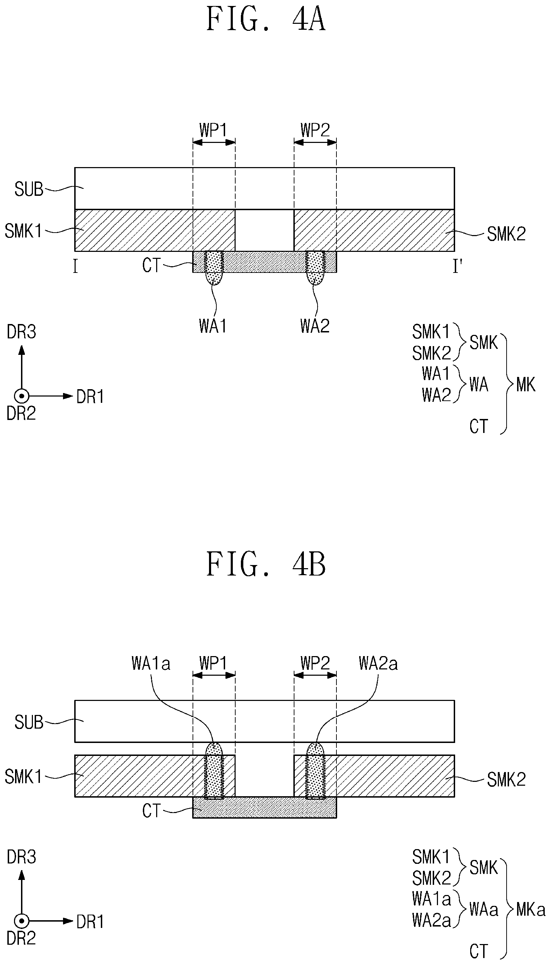

FIG. 4A is a cross-sectional view illustrating a mask and a deposition substrate disposed on the mask according to an embodiment of the present disclosure. Specifically, FIG. 4A illustrates a cross-sectional view of the mask MK corresponding to line I-I' of FIG. 3 according to an embodiment of the present disclosure. Hereinafter, repetitive descriptions will be omitted.

Referring to FIG. 4A, the welding agent WA may be formed on the bottom of the connecting stick CT. The welding agent WA may include the first welding agent WA1 overlapping the first welding part WP1 on the plane and the second welding agent WA2 overlapping the second welding part WP2 on the plane. The first welding agent WA1 and the second welding agent WA2 may be formed on the bottom of the connecting stick CT. The first welding agent WA1 may connect the connecting stick CT and the first welding part WP1, and the second welding agent WA2 may connect the connecting stick CT and the second welding part WP2.

To manufacture a display device using the mask MK of the present disclosure, the deposition substrate SUB may be disposed on the mask MK. After the first welding agent WA1 and the second welding agent WA2 are formed, the deposition substrate SUB may be disposed on the mask MK. Accordingly, for easy welding, the mask MK may be turned upside down after the first welding agent WA1 and the second welding agent WA2 are formed on the sub-mask SMK and the connecting stick CT, and then the deposition substrate SUB may be disposed on the turned sub-mask SMK.

As the first welding part WP1 and the second welding part WP2 are formed on the bottom of the connecting stick CT, the deposition substrate SUB may be directly disposed on the sub-mask SMK. Accordingly, a gap may not be generated between the sub-mask SMK and the deposition substrate SUB. Thus, surface uniformity of a deposition material formed on the deposition substrate SUB may be improved, and a display device with improved reliability may be provided.

FIG. 4B is a cross-sectional view illustrating a mask and a deposition substrate disposed on the mask according to another embodiment of the present disclosure.

Referring to FIG. 4B, a welding agent WAa may include a first welding agent WA1a disposed on a first sub-mask SMK1 and a second welding agent WA2a disposed on a second sub-mask SMK2. The mask MKa illustrated in FIG. 4B may be welded in a state in which a connecting stick CT is brought into contact with a first welding part WP1 and a second welding part WP2, and a process of turning the mask MKa upside down after the welding step may not be included. Accordingly, a process step of forming the mask MKa may be simplified compared to the embodiment of FIG. 4A.

Due to the first welding agent WA1a disposed on the first sub-mask SMK1 and the second welding agent WA2a disposed on the second sub-mask SMK2, a gap may be generated between the deposition substrate SUB disposed over the mask MKa and the sub-mask SMK. Although not illustrated, a cover layer on the first sub-mask SMK1, the second sub-mask SMK2, and the welding agent WAa may be further included. The cover layer may be a conductive layer and may cover the first sub-mask SMK1, the second sub-mask SMK2, and the welding agent WAa. Accordingly, even though the mask MKa has an uneven surface due to the welding agent WAa, the cover layer may cover the uneven surface, thereby providing a uniform surface.

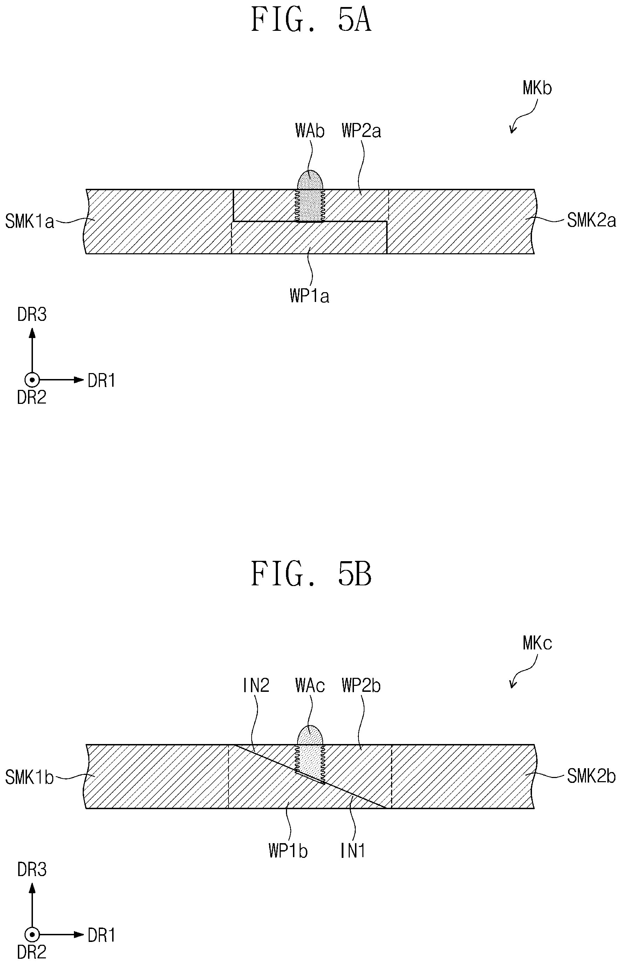

FIG. 5A is a cross-sectional view of a mask MKb according to an embodiment of the present disclosure. FIG. 5B is a cross-sectional view of a mask MKc according to an embodiment of the present disclosure.

Referring to FIG. 5A, each of a first welding part WP1a of a first sub-mask SMK1a and a second welding part WP2a of a second sub-mask SMK2a may include a stepped surface. Each of the first sub-mask SMK1a and the second sub-mask SMK2a may include a half-etched portion. Specifically, the first welding part WP1a of the first sub-mask SMK1a may have a half-etched shape in the direction opposite to the third direction DR3, and the second welding part WP2a of the second sub-mask SMK2a may have a half-etched shape in the third direction DR3. FIG. 5A illustrates an example that an upper portion of the first welding part WP1a is half-etched and a lower portion of the second welding part WP2a is half-etched. However, without being limited thereto, a lower portion of the first welding part WP1a may be half-etched, and an upper portion of the second welding part WP2a may be half-etched in another embodiment.

The first welding part WP1a and the second welding part WP2a may overlap each other on the plane. The first welding part WP1a and the second welding part WP2a may make direct contact with each other without a gap therebetween. The first welding part WP1a and the second welding part WP2a may be aligned to overlap each other on the plane. Specifically, the sum of the thicknesses of the aligned first and second welding parts WP1a and WP2a in the third direction DR3 may be equal to the thickness of the first sub-mask SMK1a in the third direction DR3. For example, the first sub-mask SMK1a may have a thickness of 50 µm or less, preferably 40 µm or less. The second sub-mask SMK2a may have the same thickness as the first sub-mask SMK1a.

A welding agent WAb may be formed on the second welding part WP2a. That is, a welding process may be performed on the second welding part WP2a in the state in which the first welding part WP1a and the second welding part WP2a make direct contact with each other. In FIG. 5A, the welding agent WAb is formed on the second welding part WP2a. However, without being limited thereto, the welding agent WAb may be formed on the bottom of the first welding part WP1a in another embodiment.

Referring to FIG. 5B, each of a first welding part WP1b of a first sub-mask SMK1b and a second welding part WP2b of a second sub-mask SMK2b may include an inclined surface. Specifically, the first welding part WP1b may include a first inclined surface IN1 that extends from an upper surface of the first sub-mask SMK1b and that is inclined in the direction opposite to the third direction DR3. The second welding part WP2b may include a second inclined surface IN2 that extends from a lower surface of the second sub-mask SMK2b and that is inclined in the third direction DR3. The first inclined surface IN1 and the second inclined surface IN2 may be parallel to each other.

The first welding part WP1b and the second welding part WP2b may overlap each other on the plane. The first welding part WP1b and the second welding part WP2b may make direct contact with each other without a gap therebetween. The first welding part WP1b and the second welding part WP2b may be aligned such that the first inclined surface IN1 and the second inclined surface IN2 face each other. Specifically, the first inclined surface IN1 may be disposed under the second inclined surface IN2.

A welding agent WAc may be formed on the second welding part WP2b. That is, a welding process may be performed on the second welding part WP2b in the state in which the first welding part WP1b and the second welding part WP2b make direct contact with each other. In FIG. 5B, the welding agent WAc is formed on the second welding part WP2b. However, without being limited thereto, the welding agent WAc may be formed on the bottom of the first welding part WP1b in another embodiment.

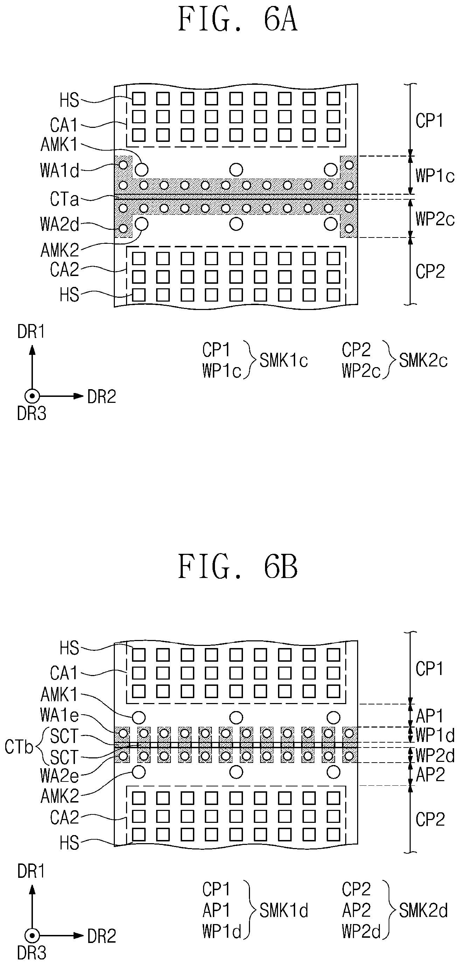

FIG. 6A is an enlarged view of a portion of a mask according to an embodiment of the present disclosure. FIG. 6B is an enlarged view of a portion of a mask according to an embodiment of the present disclosure.

Referring to FIG. 6A, a first sub-mask SMK1c may include a first central part CP1 and a first welding part WP1c extending from the first central part CP1. A second sub-mask SMK2c adjacent to the first sub-mask SMK1c may include a second central part CP2 and a second welding part WP2c extending from the second central part CP2.

The first welding part WP1c and the second welding part WP2c may correspond to the shape and size of a connecting stick CTa that overlaps the first sub-mask SMK1c and the second sub-mask SMK2c on the plane. For example, when the connecting stick CTa has the shape of "H", the first welding part WP1c may be defined as an entire region that, in the second direction DR2, overlaps the region where the first sub-mask SMK1c and the connecting stick CTa overlap each other on the plane. First welding agents WA1d may be formed on the first welding part WP1c, and second welding agents WA2d may be formed on the second welding part WP2c.

According to an embodiment of the present disclosure, first alignment marks AMK1 may be formed on the first welding part WP1c, and second alignment marks AMK2 may be formed on the second welding part WP2c. Specifically, the first alignment marks AMK1 may be formed on a region of the first welding part WP1c where the first welding agents WA1d are not formed, and the second alignment marks AMK2 may be formed on a region of the second welding part WP2c where the second welding agents WA2d are not formed. The positions in which the plurality of first alignment marks AMK1 and the plurality of second alignment marks AMK2 are formed are not limited to those illustrated in FIG. 6A. The first alignment marks AMK1 may be disposed between the first welding agents WA1d, and the second alignment marks AMK2 may be disposed between the second welding agents WA2d.

As the first alignment marks AMK1 and the first welding agents WA1d are disposed together on the first welding part WP1c and the first welding agents WA1d are disposed on the region where the first alignment marks AMK1 are not disposed, the size of a welding region between the first sub-mask SMK1c and the connecting stick CTa may be increased. In addition, as the second alignment marks AMK2 and the second welding agents WA2d are disposed together on the second welding part WP2c and the second welding agents WA2d are disposed on the region where the second alignment marks AMK2 are not disposed, the size of a welding region between the second sub-mask SMK2c and the connecting stick CTa may be increased. Thus, a coupling force between the first sub-mask SMK1c and the connecting stick CTa and a coupling force between the second sub-mask SMK2c and the connecting stick CTa may be strengthened.

Referring to FIG. 6B, a connecting stick CTb may include a plurality of sub-connecting sticks SCT. A first sub-mask SMK1d and a second sub-mask SMK2d may be connected with the plurality of sub-connecting sticks SCT. The plurality of sub-connecting sticks SCT may be arranged in the second direction DR2. That is, the plurality of sub-connecting sticks SCT may be arranged along a first long side LS1 (refer to FIG. 3) of the first sub-mask SMK1d and a second long side LS2 (refer to FIG. 3) of the second sub-mask SMK2d. The plurality of sub-connecting sticks SCT may overlap the first sub-mask SMK1d and the second sub-mask SMK2d on the plane. Specifically, the plurality of sub-connecting sticks SCT may overlap a first welding part WP1d of the first sub-mask SMK1d and a second welding part WP2d of the second sub-mask SMK2d on the plane.

Two welding agents WA1e and WA2e may be formed on one of the plurality of sub-connecting sticks SCT. Specifically, only one of a plurality of first welding agents WA1e may be formed on a portion of one of the plurality of sub-connecting sticks SCT that overlaps the first welding part WP1d in a plan view, and only one of a plurality of second welding agents WA2e may be formed on a portion of the one of the plurality of sub-connecting sticks SCT that overlaps the second welding part WP2d in a plan view. However, without being limited thereto, a plurality of first welding agents WA1e or a plurality of second welding agents WA2e may be formed on one sub-connecting stick SCT in another embodiment.

Although not illustrated, first alignment marks AMK1 may be formed on a portion of the first welding part WP1d that does not overlap the plurality of first welding agents WA1e in a plan view, and second alignment marks AMK2 may be formed on a portion of the second welding part WP2d that does not overlap the plurality of second welding agents WA2e in a plan view. Specifically, the first alignment marks AMK1 may be disposed between the plurality of first welding agents WA1e, and the second alignment marks AMK2 may be disposed between the plurality of second welding agents WA2e. Accordingly, the size of a first cell region CA1 defined in a first central part CP1 and the size of a second cell region CA2 defined in a second central part CP2 may be expanded. Thus, space efficiency of each of the first sub-mask SMK1d and the second sub-mask SMK2d may be increased.

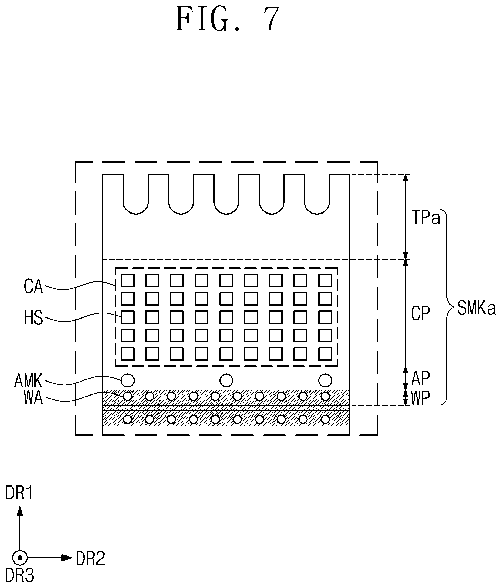

FIG. 7 is an enlarged view of a portion of a mask according to an embodiment of the present disclosure. The outermost sub-mask SMka illustrated in FIG. 7 may correspond to an embodiment in which one of the two sub-masks SMK located furthest from the middle among the plurality of sub-masks SMK illustrated in FIG. 2 and the tensile part TP are integrally formed with each other.

Referring to FIG. 7, the sub-mask SMka may include a central part CP having a cell region CA defined therein, a tensile part TPa extending from the central part CP in the first direction DR1, an alignment part AP extending from the central part CP in the direction opposite to the first direction DR1, and a welding part WP extending from the alignment part AP in the direction opposite to the first direction DR1.

The tensile part TPa may extend from the central part CP. The tensile part TPa may be a structure integrated with the central part CP by extending from the central part CP without a separate welding process. Referring to FIG. 1 together, the tensile part TPa may be directly disposed on and fixed to the mask frame MF. For example, the tensile part TPa may be fixed to the mask frame MF by clamping. After the mask MK is fixed to the mask frame MF, a portion of the tensile part TPa may be removed.

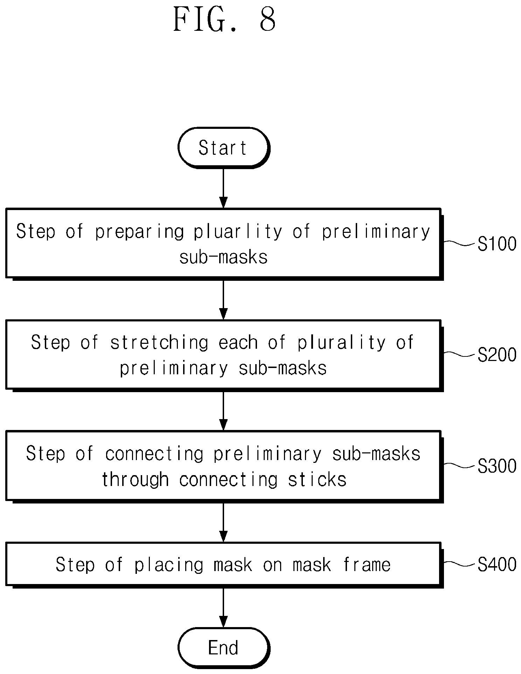

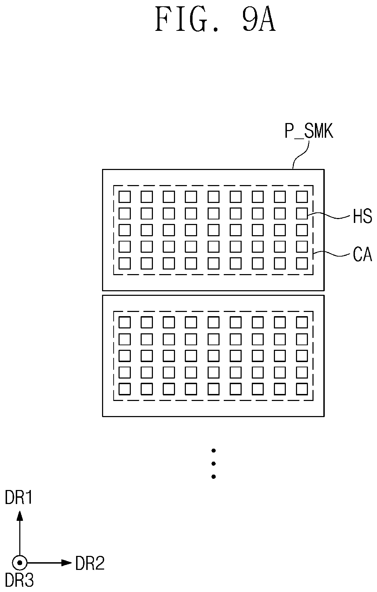

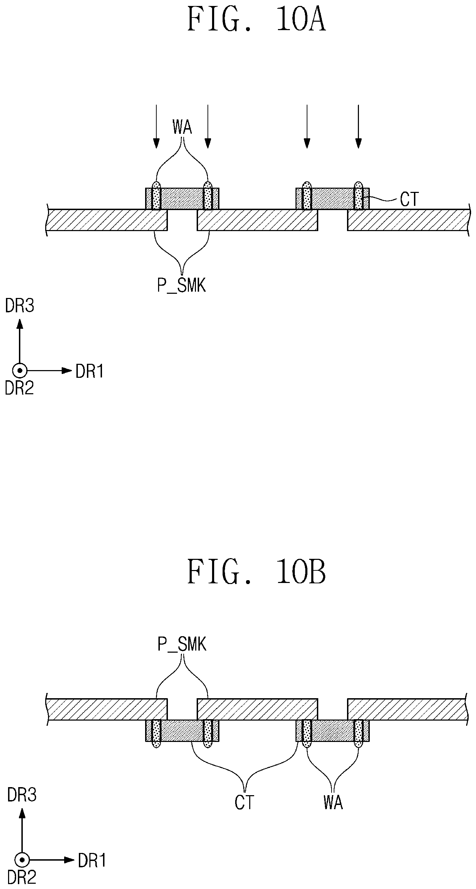

FIG. 8 is a flowchart illustrating a method of manufacturing a mask assembly according to an embodiment of the present disclosure. FIGS. 9A to 9F are schematic process views illustrating processes of manufacturing the mask assembly according to an embodiment of the present disclosure. FIGS. 10A to 10C are schematic process views illustrating processes of manufacturing the mask assembly according to an embodiment of the present disclosure. Hereinafter, the present disclosure will be described with reference to FIGS. 8 to 10C.

Referring to FIGS. 8 and 9A together, step S100 of preparing a plurality of preliminary sub-masks P_SMK may be performed. The plurality of preliminary sub-masks P_SMK may be separately formed. Specifically, the plurality of preliminary sub-masks P_SMK may be separately formed through a photolithography process. For example, each of the preliminary sub-masks P_SMK may have photoresist on upper and lower surfaces thereof and may be disposed on a roller. The roller may be rotated to move a predetermined portion of the mask sheet to be exposed into an exposure module. An exposure process may be performed on the moved portion of the mask sheet. Thereafter, a plurality of holes HS may be formed in a cell region CA through a developing process. Specifically, the plurality of holes HS may be formed in the preliminary sub-mask P_SMK through a plurality of steppers. That is, each of the plurality of preliminary sub-masks P_SMK may include a central part CP in which the cell region CA including the plurality of holes HS is defined.

The plurality of preliminary sub-masks P_SMK formed through the above-described process may be arranged in the first direction DR1 and may include short sides extending in the first direction DR1 and long sides extending in the second direction DR2. As the plurality of preliminary sub-masks P_SMK have the same shape and size, the long sides of the plurality of preliminary sub-masks P_SMK may have the same length, and the short sides of the plurality of preliminary sub-masks P_SMK may have the same length. For example, the long sides of the plurality of preliminary sub-masks P_SMK may have a length of about 300 mm to about 2000 mm, and the short sides of the plurality of preliminary sub-masks P_SMK may have a length of about 90 mm to about 400 mm.

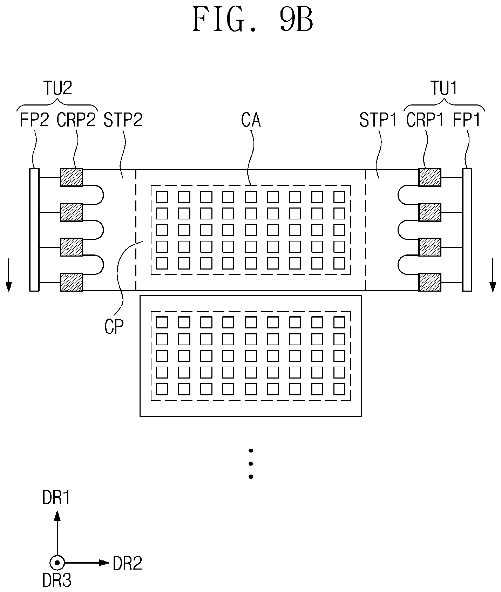

Referring to FIGS. 8 and 9B together, step S200 of stretching each of the plurality of preliminary sub-masks P_SMK may be performed. Each of the plurality of preliminary sub-masks P_SMK may include a first sub-tensile part STP1 extending from the central part CP in the second direction DR2 and a second sub-tensile part STP2 extending from the central part CP in the direction opposite to the second direction DR2.

According to an embodiment of the present disclosure, step S200 of stretching each of the plurality of preliminary sub-masks P_SMK may include a step of stretching the first sub-tensile part STP1 in the second direction DR2 using a first stretching unit TU1 connected with the first sub-tensile part STP1 and a step of stretching the second sub-tensile part STP2 in the direction opposite to the second direction DR2 using a second stretching unit TU2 connected with the second sub-tensile part STP2.

Each of the first sub-tensile part STP1 and the second sub-tensile part STP2 may include a plurality of protrusions and a plurality of depressions. The plurality of protrusions may be portions directly connected with the first stretching unit TU1 and the second stretching unit TU2. Specifically, the first stretching unit TU1 may include a first fixing part FP1 and a plurality of first clampers CRP1, and the second stretching unit TU2 may include a second fixing part FP2 and a plurality of second clampers CRP2. The plurality of first clampers CRP1 may hold the protrusions of the first sub-tensile part STP1 and then may stretch the preliminary sub-mask P_SMK in the second direction DR2. At the same time, the plurality of second clampers CRP2 may hold the protrusions of the second sub-tensile part STP2 and then may stretch the preliminary sub-mask P_SMK in the direction opposite to the second direction DR2.

In FIG. 9B, each of the first sub-tensile part STP1 and the second sub-tensile part STP2 is illustrated as including four protrusions and three depressions. However, without being limited thereto, the numbers of protrusions and depressions included in the first sub-tensile part STP1 may vary depending on the number of first clampers CRP1, and the numbers of protrusions and depressions included in the second sub-tensile part STP2 may vary depending on the number of second clampers CRP2. In addition, the depressions are illustrated as having a semicircular shape, and the protrusions are illustrated as having a quadrangular shape. However, without being limited thereto, the protrusions and the depressions may have various shapes.

Each of the first stretching unit TU1 and the second stretching unit TU2 may move. The first stretching unit TU1 and the second stretching unit TU2 may stretch the outermost preliminary sub-mask P_SMK, which is disposed furthest from the middle in the first direction DR1, in the second direction DR2 and the direction opposite to the second direction DR2 and then may move in the direction opposite to the first direction DR1. The moved first and second stretching units TU1 and TU2 may stretch, in the second direction DR2 and the direction opposite to the second direction DR2, a preliminary sub-mask P_SMK adjacent to the stretched preliminary sub-mask P_SMK in the first direction DR1. The movement of the first stretching unit TU1 and the second stretching unit TU2 may be performed through a separate moving member. However, without being limited thereto, the first stretching unit TU1 and the second stretching unit TU2 may be fixed, and the stretching step may be performed while the plurality of preliminary sub-masks P_SMK directly move in the first direction DR1 or the direction opposite to the first direction DR1 in another embodiment.

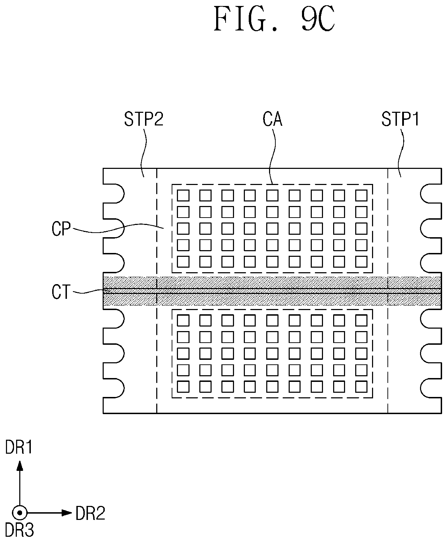

As illustrated in FIG. 9C, the preliminary sub-masks P_SMK, the long sides of which have the same length, may be arranged in the first direction DR1 after the first stretching unit TU1 and the second stretching unit TU2 stretch all of the preliminary sub-masks P_SMK while moving in the direction opposite to the first direction DR1.

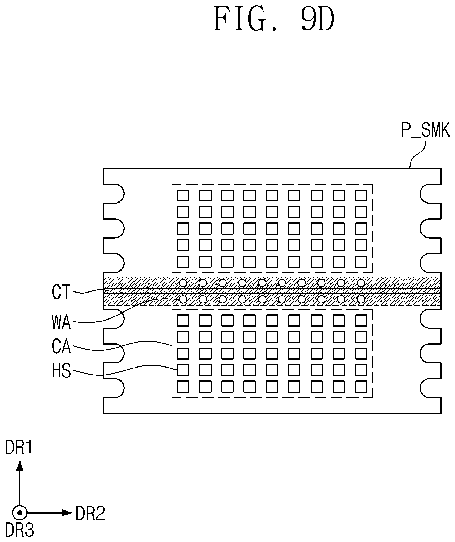

Referring to FIGS. 8, 9C, and 9D together, step S300 of connecting two preliminary sub-masks P_SMK adjacent to each other in the first direction DR1 through a connecting stick CT may be performed. The connecting stick CT may be disposed under the two adjacent preliminary sub-masks P_SMK and may connect the two adjacent preliminary sub-masks P_SMK.

Specifically, referring to FIGS. 9D and 10A together, each of a plurality of connecting sticks CT may be disposed on two preliminary sub-masks P_SMK adjacent to each other among the plurality of preliminary sub-masks P_SMK. Thereafter, a welding process may be performed on portions where the connecting stick CT overlaps the two preliminary sub-masks P_SMK in a plan view. After the welding process is performed, welding agents WA having a protruding shape may be formed on the connecting stick CT.

Referring to FIG. 10B, after the welding process is completed, the plurality of preliminary sub-masks P_SMK connected by the connecting sticks CT may be turned upside down. Because the process of turning the plurality of preliminary sub-masks P_SMK upside down is included, a gap may not be generated between the sub-mask SMK and the deposition substrate SUB as described with reference to FIG. 4A even though the deposition substrate SUB is disposed on the sub-mask SMK.

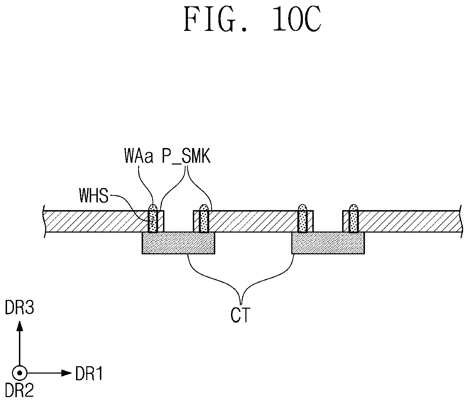

Referring to FIG. 10C, welding agents WAa may be formed in a plurality of welding holes WHS defined in the preliminary sub-masks P_SMK. Specifically, the plurality of welding holes WHS may be formed through the preliminary sub-masks P_SMK up to the connecting sticks CT in the direction opposite to the third direction DR3, and the welding agents WAa may fill the plurality of welding holes WHS and may protrude above the preliminary sub-masks P_SMK. After the plurality of welding holes WHS are formed, a process of welding the preliminary sub-masks P_SMK and the connecting sticks CT may be performed.

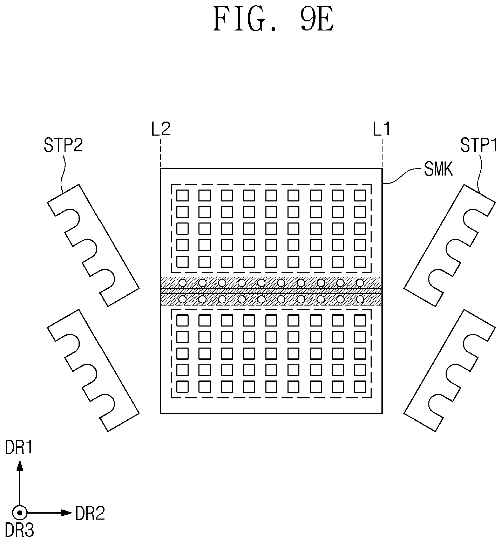

Referring to FIG. 9E, a process of cutting the first sub-tensile part STP1 and the second sub-tensile part STP2 included in each of the plurality of preliminary sub-masks P_SMK may be performed. The cutting process may be performed by applying a laser. The first sub-tensile parts STP1 may be cut by applying a laser to the plurality of preliminary sub-masks P_SMK along a first line L1. At the same time, the second sub-tensile parts STP2 may be cut by applying a laser to the plurality of preliminary sub-masks P_SMK along a second line L2. A plurality of sub-masks SMK of the present disclosure may be provided by performing the cutting process on the plurality of preliminary sub-masks P_SMK.

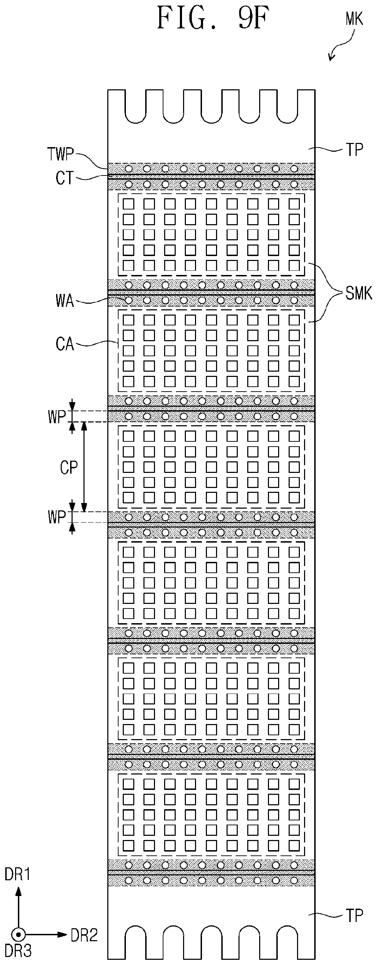

Referring to FIG. 9F, two tensile parts TP connected with two sub-masks SMK (i.e., outermost sub-masks) disposed furthest from the middle in the first direction DR1 and the direction opposite to the first direction DR1 among the plurality of sub-masks SMK may be provided. The two tensile parts TP may be connected with the two sub-masks SMK adjacent to the two tensile parts TP, respectively, through a welding process. The welding process may be the same as the above-described welding process for connecting the preliminary sub-masks P_SMK (refer to FIG. 9D). As illustrated in FIG. 9F, the two tensile parts TP may be provided separately from the sub-masks SMK. In this case, each of the two tensile parts TP includes a tensile welding part TWP, and the tensile welding part TWP and the welding part WP of the adjacent outermost sub-mask SMK may be connected by the connecting stick CT. However, without being limited thereto, as illustrated in FIG. 7, the two tensile parts TP may be provided as parts of the two outermost sub-masks SMK disposed furthest from the middle in the first direction DR1 and the direction opposite to the first direction DR1 among the plurality of sub-masks SMK in another embodiment.

Referring to FIGS. 1, 8, and 9F together, step S400 of placing a mask MK on a mask frame MF may be performed. As the two tensile parts TP are provided, the mask MK of the present disclosure may be formed. The formed mask MK may be provided in plural numbers. The plurality of masks MK may be directly disposed on the mask frame MF and may be fixed to the mask frame MF. Specifically, the tensile parts TP included in the plurality of masks MK may be directly disposed on the mask frame MF and may be fixed to the mask frame MF. Accordingly, the mask assembly MA of the present disclosure may be provided.

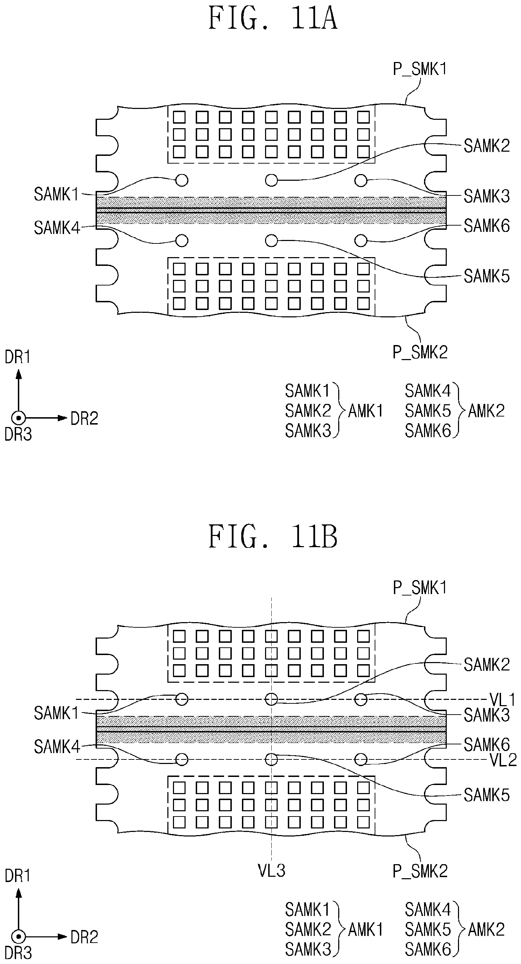

FIGS. 11A to 11C are views illustrating a step of determining whether two adjacent preliminary sub-masks P_SMK are aligned with each other according to an embodiment of the present disclosure. Only some of the plurality of preliminary sub-masks P_SMK are illustrated in FIGS. 11A to 11C. For convenience of description, the two adjacent preliminary sub-masks P_SMK are referred to as the first preliminary sub-mask P_SMK 1 and the second preliminary sub-mask P_SMK2. An alignment step may be a step performed prior to step S300 of connecting the preliminary sub-masks P_SMK through the connecting sticks CT (refer to FIG. 9D).

Referring to FIG. 11A, a step of forming a first alignment mark AMK1 on the first preliminary sub-mask P_SMK1 and forming a second alignment mark AMK2 on the second preliminary sub-mask P_SMK2 may be performed. The first alignment mark AMK1 and the second alignment mark AMK2 may be formed through an exposure process. That is, through the exposure process using photoresist, the first alignment mark AMK1 may be formed on the first preliminary sub-mask P_SMK1, and the second alignment mark AMK2 may be formed on the second preliminary sub-mask P_SMK2.

The first alignment mark AMK1 may include a plurality of sub-alignment marks SAMK1, SAMK2, and SAMK3. Specifically, the first alignment mark AMK1 may include the first sub-alignment mark SAMK1 and the third sub-alignment mark SAMK3 that are disposed furthest from the middle in the second direction DR2 and the second sub-alignment mark SAMK2 disposed between the first sub-alignment mark SAMK1 and the third sub-alignment mark SAMK3. Furthermore, the second alignment mark AMK2 may include a plurality of sub-alignment marks SAMK4, SAMK5, and SAMK6. Specifically, the second alignment mark AMK2 may include the fourth sub-alignment mark SAMK4 and the sixth sub-alignment mark SAMK6 that are disposed furthest from the middle in the second direction DR2 and the fifth sub-alignment mark SAMK5 disposed between the fourth sub-alignment mark SAMK4 and the sixth sub-alignment mark SAMK6.

The number of sub-alignment marks SAMK1, SAMK2, SAMK3, SAMK4, SAMK5, and SAMK6 is not limited to that illustrated and may be determined depending on the number of exposure holes that form the sub-alignment marks SAMK1, SAMK2, SAMK3, SAMK4, SAMK5, and SAMK6.

Referring to FIG. 11B, a step of determining alignment of the first preliminary sub-mask P_SMK1 and the second preliminary sub-mask P_SMK2 using the plurality of sub-alignment marks SAMK1, SAMK2, SAMK3, SAMK4, SAMK5, and SAMK6 may be performed. The plurality of sub-alignment marks SAMK1, SAMK2, SAMK3, SAMK4, SAMK5, and SAMK6 may be formed by changing chemical properties of initial photoresist by exposure and thus may be easily visually recognized through a special camera.

Specifically, first, whether the first sub-alignment mark SAMK1, the second sub-alignment mark SAMK2, and the third sub-alignment mark SAMK3 are aligned may be determined through the special camera. That is, a first virtual line VL1 parallel to the second direction DR2 may be set, and whether the first sub-alignment mark SAMK1, the second sub-alignment mark SAMK2, and the third sub-alignment mark SAMK3 are aligned along the first virtual line VL1 may be determined.

Next, whether the fourth sub-alignment mark SAMK4, the fifth sub-alignment mark SAMK5, and the sixth sub-alignment mark SAMK6 are aligned may be determined through the special camera. That is, a second virtual line VL2 parallel to the second direction DR2 may be set, and whether the fourth sub-alignment mark SAMK4, the fifth sub-alignment mark SAMK5, and the sixth sub-alignment mark SAMK6 are aligned along the second virtual line VL2 may be determined.

Finally, whether the second sub-alignment mark SAMK2 and the fifth sub-alignment mark SAMK5 are aligned may be determined. That is, a third virtual line VL3 parallel to the first direction DR1 may be set, and whether the second sub-alignment mark SAMK2 and the fifth sub-alignment mark SAMK5 are aligned along the third virtual line VL3 may be determined. A failure in alignment may be determined by quantifying the degree of misalignment of the second sub-alignment mark SAMK2 and the fifth sub-alignment mark SAMK5 with respect to the third virtual line VL3, and the first preliminary sub-mask P_SMK1 and the second preliminary sub-mask P_SMK2 may be rearranged based on the determination.

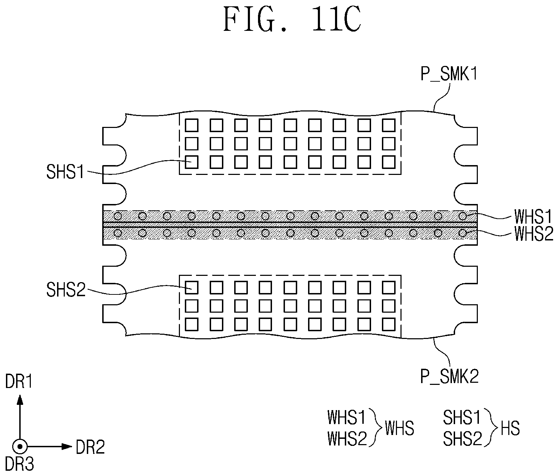

Referring to FIG. 11C, a step of determining alignment of the first preliminary sub-mask P_SMK1 and the second preliminary sub-mask P_SMK2 through a plurality of holes HS or a plurality of welding holes WHS formed in the first preliminary sub-mask P_SMK1 and the second preliminary sub-mask P_SMK2 may be performed.

For example, virtual lines may be drawn on first outermost holes SHS1 adjacent to the second preliminary sub-mask P_SMK2 among the plurality of holes HS included in the first preliminary sub-mask P_SMK1 and second outermost holes SHS2 adjacent to the first preliminary sub-mask P_SMK1 among the plurality of holes HS included in the second preliminary sub-mask P_SMK2, and whether the first preliminary sub-mask P_SMK1 and the second preliminary sub-mask P_SMK2 are aligned may be determined through the special camera.

In addition, virtual lines may be drawn on first welding holes WHS1 formed in the first preliminary sub-mask P_SMK1 and second welding holes WHS2 formed in the second preliminary sub-mask P_SMK2, and whether the first preliminary sub-mask P_SMK1 and the second preliminary sub-mask P_SMK2 are aligned may be determined through the special camera.

In FIGS. 8 to 11C, an embodiment that the process of cutting the first sub-tensile part STP1 and the second sub-tensile part STP2 included in each of the plurality of preliminary sub-masks P_SMK is performed after connecting two preliminary sub-masks P_SMK adjacent to each other in the first direction DR1 through a connecting stick CT is performed is illustrated. However, the present invention is not limited thereto. In another embodiment, the process of cutting the first sub-tensile part STP1 and the second sub-tensile part STP2 included in each of the plurality of preliminary sub-masks P_SMK is performed and then connecting two sub-masks SMK adjacent to each other in the first direction DR1 through a connecting stick CT is performed. All descriptions above regarding FIGS. 8 to 11C modified by this sequence change can be applied to this embodiment.

As described above, the mask of the mask assembly of the present disclosure may be formed by connecting the plurality of sub-masks using the connecting sticks. Accordingly, a display device having a size corresponding to each sub-mask may be provided.

While the present disclosure has been described with reference to embodiments thereof, it will be apparent to those of ordinary skill in the art that various changes and modifications may be made thereto without departing from the scope of the present disclosure as set forth in the following claims.

## Claims

1. A mask assembly comprising:
a mask; and
a mask frame configured to support the mask,
wherein the mask includes:
a plurality of sub-masks arranged in a first direction, the plurality of sub-masks each including a short side configured to extend in the first direction and a long side configured to extend in a second direction crossing the first direction; and
a first connecting stick configured to overlap the long side on in a plan view and connect two sub-masks adjacent to each other among the plurality of sub-masks,
wherein each of the plurality of sub-masks includes:
a central part including a cell region defining a plurality of holes therein; and
a welding part disposed along the long side, and
wherein the first connecting stick and the welding part are connected with each other through a plurality of welding agents.

2. The mask assembly of claim 1, wherein the first connecting stick is disposed under the two sub-masks adjacent to each other and partially overlaps the welding part included in each of the two sub-masks in the plan view, and optionally wherein the plurality of welding agents overlap the welding part and the first connecting stick in the plan view.

3. The mask assembly of claim 2, wherein the plurality of welding agents are disposed under the first connecting stick.

4. The mask assembly of claim 2 or claim 3, wherein the plurality of welding agents are disposed on the welding part.

5. The mask assembly of any one of claims 2 to 4, wherein the plurality of welding agents do not overlap the central part in the plan view.

6. The mask assembly of any one of the preceding claims, wherein the first connecting stick and the welding part partially overlap each other in the plan view.

7. The mask assembly of any one of the preceding claims, wherein each of the plurality of sub-masks further includes an alignment part having an alignment mark to determine whether the two sub-masks adjacent to each other among the plurality of sub-masks are aligned with each other, and optionally wherein the alignment part is disposed between the central part and the welding part.

8. The mask assembly of claim 7, wherein the alignment mark includes a photoresist pattern.

9. The mask assembly of claim 7 or claim 8, wherein the alignment mark is provided in plurality, and
wherein the plurality of alignment marks are aligned in the second direction, and optionally wherein each of the plurality of sub-masks includes:
a first alignment part disposed in the first direction with respect to the central part; and
a second alignment part disposed opposite to the first alignment part with respect to the central part.

10. The mask assembly of claim 9, wherein the plurality of alignment marks include:
a plurality of first alignment marks defined on the first alignment part; and
a plurality of second alignment marks defined on the second alignment part, and optionally wherein the plurality of first alignment marks defined on one sub-mask among the plurality of sub-masks and the plurality of second alignment marks defined on another sub-mask adjacent to the one sub-mask are aligned with each other in the first direction.

11. The mask assembly of any one of the preceding claims, wherein the cell region is singly provided in the central part.

12. The mask assembly of any one of the preceding claims, wherein the mask further includes two tensile parts connected with two outermost sub-masks in the first direction and a direction opposite to the first direction, respectively, among the plurality of sub-masks, and
wherein the two tensile parts are fixed to the mask frame, and optionally wherein the mask further includes a second connecting stick configured to connect the two outermost sub-masks with the two tensile parts,
wherein each of the two tensile parts includes a tensile welding part, and
wherein the tensile welding part and the welding part are connected by the second connecting stick.

13. The mask assembly of any one of the preceding claims, wherein the first connecting stick is provided in plurality, and
wherein the plurality of first connecting sticks are arranged in the first direction, and optionally either each of the plurality of first connecting sticks extends along the long side or each of the plurality of first connecting sticks includes a plurality of sub-connecting sticks arranged along the long side.

14. The mask assembly of any one of the preceding claims, wherein the short side has a length of about 90 millimeters (mm) to about 400 mm, and
wherein the long side has a length of about 300 mm to about 2000 mm.

15. A mask assembly comprising:
a mask; and
a mask frame configured to support the mask,
wherein the mask includes a plurality of sub-masks arranged in a first direction, the plurality of sub-masks each including a short side configured to extend in the first direction and a long side configured to extend in a second direction crossing the first direction,
wherein each of the plurality of sub-masks includes:
a central part including a single cell region defining a plurality of holes therein; and
a welding part configured to extend from the central part and adjacent to the long side, and
wherein welding parts included in two sub-masks adjacent to each other among the plurality of sub-masks are connected with each other.

16. The mask assembly of claim 15, wherein the mask further includes a connecting stick configured to overlap the long side in a plan view and connect the two sub-masks adjacent to each other, and optionally wherein the connecting stick and the welding part partially overlap each other in the plan view.

17. The mask assembly of claim 15, wherein the welding parts included in the two sub-masks adjacent to each other make direct contact with each other, and optionally wherein each of the welding parts included in the two sub-masks adjacent to each other includes an inclined surface or a stepped surface.

18. A method for manufacturing a mask assembly, the method comprising:
preparing a plurality of preliminary sub-masks arranged in a first direction, the plurality of preliminary sub-masks each including a short side configured to extend in the first direction and a long side configured to extend in a second direction crossing the first direction;
stretching the plurality of preliminary sub-masks in the second direction and a direction opposite to the second direction to provide a plurality of sub-masks;
connecting two sub-masks adjacent to each other among the plurality of sub-masks through a connecting stick to provide a mask; and
placing the mask on a mask frame,
wherein each of the plurality of sub-masks includes:
a central part including a cell region defining a plurality of holes therein; and
a welding part adjacent to the long side and configured to make contact with the connecting stick, and
wherein the connecting stick and the welding part partially overlap each other in a plan view.

19. The method of claim 18, wherein each of the plurality of preliminary sub-masks includes:
a first sub-tensile part configured to extend from the central part in the second direction; and
a second sub-tensile part configured to extend from the central part in the direction opposite to the second direction, and optionally wherein the stretching of the plurality of preliminary sub-masks includes:
stretching the first sub-tensile part in the second direction using a first stretching unit connected with the first sub-tensile part; and
stretching the second sub-tensile part in the direction opposite to the second direction using a second stretching unit connected with the second sub-tensile part, and optionally the plurality of sub-masks are provided by cutting the first sub-tensile part and the second sub-tensile part after the stretching of the first sub-tensile part and the second sub-tensile part.

20. The method of claim 18 or claim 19, wherein the connecting of the two sub-masks through the connecting stick includes:
placing the connecting stick on the welding part; and
welding the welding part and the connecting stick to form a welding agent on the connecting stick.

21. The method of any one of claims 18 to 20, wherein the connecting of the two sub-masks through the connecting stick includes:
placing the connecting stick under the welding part; and
welding the welding part and the connecting stick to form a welding agent on the welding part.

22. The method of any one of claims 18 to 21, further comprising:
determining whether the sub-masks are aligned, before the connecting of the two sub-masks through the connecting stick, and optionally wherein determining whether the sub-masks are aligned includes:
determining whether the sub-masks are aligned, by using outmost holes , among the plurality of holes included in one of the two sub-masks, adjacent to another sub-mask of the two sub-masks.

23. The method of claim 22, wherein the sub-masks defines a welding hole therein in which a welding agent is formed, and
wherein determining whether the sub-masks are aligned includes determining whether the sub-masks are aligned, by using the welding hole.

24. The method of claim 22 or claim 23, wherein each of the plurality of sub-masks further includes an alignment part having an alignment mark defined thereon, and
wherein determining whether the sub-masks are aligned further includes forming the alignment mark on the alignment part, and optionally wherein determining whether the sub-masks are aligned further includes determining whether the sub-masks are aligned, by using the alignment mark.

25. The method of any one of claims 18 to 24, wherein each of two outermost sub-masks in the first direction and a direction opposite to the first direction, respectively, among the plurality of sub-masks further includes a tensile part configured to extend from the central part, and optionally further comprising:
stretching the sub-masks by stretching the tensile parts of the two outermost sub-masks in the first direction and the direction opposite to the first direction, after the connecting of the two adjacent sub-masks through the connecting stick; and
fixing the sub-masks to the mask frame.
